(19) **Europäisches Patentamt / European Patent Office / Office européen des brevets**

(11) **EP 4 726 341 A1**

(12) **EUROPEAN PATENT APPLICATION**

(43) Date of publication:
**15.04.2026 Bulletin 2026/16**

(21) Application number: **24383106.2**

(22) Date of filing: **10.10.2024**

(51) International Patent Classification (IPC):
$G01J\ 5/02$ (2022.01)     $B82Y\ 20/00$ (2011.01)
$B82Y\ 30/00$ (2011.01)     $G01J\ 5/04$ (2006.01)
$G01J\ 5/08$ (2022.01)     $G01J\ 5/20$ (2006.01)

(52) Cooperative Patent Classification (CPC):
**G01J 5/024; B82Y 20/00; B82Y 30/00; G01J 5/046;
G01J 5/0853; G01J 5/20**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Fundació Institut de Ciències Fotòniques
08860 Castelldefels (ES)**
• **Institució Catalana De Recerca I
Estudis Avançats (ICREA)
08010 Barcelona (ES)**

(72) Inventors:
• **KONSTANTATOS, Gerasimos
08860 CASTELLDEFELS, BARCELONA (ES)**
• **KUMAR, Gaurav
CASTELLDEFELS, BARCELONA (ES)**

(74) Representative: **Balder IP Law, S.L.
Paseo de la Castellana 93
5ª planta
28046 Madrid (ES)**

(54) **THERMISTOR, BOLOMETER, AND IMAGE SENSOR**

(57) A thermistor comprising two electrodes (2, 3) and a layered structure (4) in contact with the two electrodes (2, 3), wherein the layered structure (4) comprises at least one first layer (4a) comprising first colloidal quantum dots, and at least one second layer (4b) comprising second colloidal quantum dots which differ from the first colloidal quantum dots. Also, a bolometer comprising a thermistor. Also, an image sensor comprising a plurality of pixels, wherein each pixel comprises a respective bolometer.

FIG. 1A

FIG. 1B

EP 4 726 341 A1

**Description**

**TECHNICAL FIELD**

The present invention relates to a thermistor. Also, the present invention relates to a bolometer and an image sensor.

**STATE OF THE ART**

There are known conventional thermistors, bolometers and image sensors which are devices which comprise semiconductor materials which exhibit a temperature-dependent resistivity. Thermistors are typically used for measuring temperatures or sensing temperature variations/changes, and bolometers are typically used for measuring radiant heat by means of the change that the radiant heat causes on the resistance of a semiconductor material of the bolometer. For this purpose, some known conventional bolometers, in additional to their respective semiconductor material whose resistivity is temperature dependent, further comprise an absorber which is suitable for absorbing the radiant heat that should be measured, and said absorber is thermally connected to the semiconductor material for passing to the latter heat that is generated in the bolometer as a result of the absorption of the radiant heat by the absorber. It is also noted that some of the known bolometers, since they are suitable for measuring radiant heat and, hence, IR radiation, are utilized as components of certain types of image sensors such as thermal cameras. Hence, there are known IR-sensitive image sensors that comprise known conventional bolometers.

A problem with several of the aforementioned known conventional thermistors, bolometers and image sensors is that their respective semiconductor materials that exhibit a temperature-sensitive resistivity offer a limited degree of material engineering and control over the material properties which may crucially affect the performance of the devices comprising said semiconductor materials. One such important property of a semiconductor material used as a temperature-sensitive resistor is the material's temperature coefficient of resistance (TCR) which is a measure of how much the resistance of a material changes with temperature. The TCR is defined as the change in resistance per unit change in temperature, usually expressed as a percentage per degree Kelvin by the following equation:

$$\mathrm{TCR}, a = \frac{1}{R}\frac{dR}{dT} \qquad \text{(equation 1)}$$

where R and T denote resistance and temperature, respectively. For a semiconductor the value of TCR is typically negative i.e., the resistance decreases with an increase in the temperature due to an increase in the free charge carrier concentration.

A parameter of the semiconductor material that can affect crucially the material's TCR value is the activation energy $E_a$ for the transport of charge carriers. The activation energy represents the energy required for a carrier to overcome the potential energy barrier at a point in the material and move to another point. For a carrier to move from one location to another, it must acquire enough energy to overcome the potential energy barrier that exists between the two points. $E_a$ is the minimum amount of energy required to enable this process to occur. In semiconductor thin films, $E_a$ is typically associated with the energy required to move a carrier from the valence band (VB) to the conduction band (CB) for a homogenous film, while for a non-homogenous or a composite film, additional potential energy variations between the non-identical parts of the film will also come into play. To move an electron from the VB to the CB (to overcome electronic potential variations in the case of composite films), it must acquire energy equal to or greater than the bandgap energy. This energy may come from a variety of sources, such as thermal energy, electric fields, or photons. Typically, TCR is related to the activation energy for the transport of carriers in a material by the following equation:

$$\mathrm{TCR}, a = \frac{-E_a}{kT^2} \qquad \text{(equation 2)}$$

where k is the Boltzmann constant. Hence, the activation energy of a semiconductor material may crucially affect the material's TCR. However, many of the conventional thermistors, bolometers and related image sensors rely on conventional bulk or thin film semiconductor materials whose activation energy imposes a limit to the TCR of the material and to the overall performance of the device employing the semiconductor material. In addition, said conventional bulk or thin film semiconductor materials allow for a limited degree of engineering of their electronic properties, and especially of their TCR. Moreover, the production of conventional bulk or thin film semiconductor materials may require expensive, slow and/or energy intensive manufacturing processes. In addition, several of the conventional known types of bolometers and related image sensors, can suffer from: i) high noise, such as Johnson noise (or Nyquist or thermal noise), Thermal fluctuation noise or background fluctuation noise, ii) low responsivity, iii) low detectivity. Therefore, there is a need for thermistors, bolometers and image sensors that overcomes at least some of the drawbacks of the conventional ones.

**DESCRIPTION OF THE INVENTION**

The present invention allows for obtaining thermistors, bolometers and related image sensors which overcome many of the drawbacks of the known conventional respective devices. In particular, the present invention allows for obtaining devices which exhibit good performance and comprise semiconductor materials the electronic properties of which may be precisely controlled and optimized for the purpose of optimizing the performance of the devices employing these materials. Moreover, the electronic properties of said semiconductor materials may advantageously be optimized in a cost-effective manner using solution processing. Consequently, the present invention may advantageously allow for obtaining devices which exhibit good characteristics, such as for example good TCR, noise, detectivity and responsivity, which, at least in some cases, may be better compared to the corresponding characteristic of many of the known conventional devices. Moreover, at least some embodiments of the present invention comprise materials which can be fabricated and processed at large scale with simple solution processing, and therefore at a reduced cost compared to some semiconductors found in the known conventional devices. In addition, at least some embodiments of the present invention may advantageously be fabricated using processes and materials which are compatible with known complementary metal-oxide-semiconductor (CMOS) technology, and this may facilitate the deployment and commercialization of the corresponding embodiments.

A first aspect of the invention concerns a thermistor which comprises two electrodes and a layered structure in contact with the two electrodes. The layered structure comprises at least one first layer comprising first colloidal quantum dots, and at least one second layer comprising second colloidal quantum dots. The second colloidal quantum dots differ from the first colloidal quantum dots.

Colloidal quantum dots (CQDs) are materials which may be produced and processed with solution-based methods, and there are several known such methods which further allow for accurately controlling and tailoring the exact properties of the CQDs being produced or processed. In addition, many of said solution-based methods are compatible with thin film- or CMOS-technology and are suitable for the production of CQDs and CQD-containing materials at large quantities. This may advantageously facilitate the large-scale and cost-effective production of the thermistors and the other devices according to the invention.

It may be understood that a factor that may critically influence and determine to a large extend the operation and performance of the thermistor of the first aspect of the invention is how the electrical resistivity of the layered structure of the device may depend on and change with the temperature. The resistivity (i.e. electrical resistivity) of the layered structure may vary significantly with the temperature, due to the presence of the first and second colloidal quantum dots in the corresponding layers of the layered structure. Colloidal quantum dots (QCDs) are a type of semiconductor particles whose electronic structure and electronic properties may depend strongly on any of the structure, morphology, size, diameter, composition, stoichiometry and surface chemistry of the particles. Hence, the activation energy of the layered structure that comprises the first and second CQDs may be controlled via the material engineering of the CQDs, and said material engineering may comprise controlling any of the structure, morphology, size, diameter, composition, stoichiometry and surface chemistry of the first CQDs and second CQDs. It is noted that among the properties that may be controlled via the material engineering of the first and second CQDs is the corresponding electronic doping, the valence band level ($E_{VB}$), the conduction band level ($E_{VB}$) and the Fermi levels ($E_F$) of each of the at least one first layer and the at least second layer comprising the first CQDs and second CQDs respectively. This may in turn allow for controlling the relative positions of the $E_{VB}$, $E_{CB}$ and $E_F$ of the at one least first layer with respect to the corresponding levels of the at least second layer, for eventually controlling the activation energy corresponding to a possible interlayer charge transport between the at least one first layer and the at least one second layer of the thermistor. Such control of the possible interlayer charge transport may advantageously result to the optimization of the performance of embodiments of the invention. It is also noted that the control of the properties of the CQDs within an individual layer of the layered structure, may also affect an activation energy related to a corresponding charge transport that may occur within the individual layer. The charge transport that may occur within a particular layer of the layered structured may be referred to as "intralayer" charge transport for being distinguished from the aforementioned interlayer charge transport. Hence, the properties of the CQDs, such as the size, morphology, structure, stoichiometry and surface chemistry of the CQDs of an individual layer of the layered structure, may also be controlled for controlling the resistivity of the individual layer, and the temperature dependence of said resistivity of the individual layer. Such control may optionally also be advantageously utilized for the optimization of the structure and performance of the overall device.

In a preferred embodiment of the invention, the at least one first layer and the at least one second layer exhibit, i.e. are configured to exhibit, with respect (i.e. compared) to each other any of a different doping, a different Fermi level or a band offset. The possible presence and optimization of a doping difference or band offset between the different layers of the layered structure may advantageously result to an improvement of the performance of the thermistor. It is noted that said doping difference may refer to a difference of the majority carrier types of the different layers of the layered structure, or to a difference of the majority or minority carrier concentrations of the different layers. Also, the aforementioned band offset may refer to an offset between any of the corresponding $E_{VB}$ or $E_{CB}$ of the different layers. For example, the aforementioned band offset may preferably refer to a possible offset between a valence band level ($E_{VB1}$) of the at least one first layer and a valence band level ($E_{VB2}$) of the at least one second layer, and/or or to a possible offset between a conduction band level ($E_{CB1}$) of the at least one first layer and a conduction band level ($E_{VB2}$) of the at least one second layer. Also, the aforementioned Fermi level difference may refer to a possible difference between a Fermi level ($E_{FB1}$) of the at least one first layer and a Fermi level ($E_{VB2}$) of the at least one second layer.

The possible creation of a band offset and/or doping difference between different CQD-containing layers of the interlayer structure, wherein said different layers compared to each other comprise different CQDs, may be achieved via the presence of a corresponding difference of one or more properties of the different CQDs. Hence, the first and second CQDs may be configured so that there is an electronic band offset between the first and second colloidal quantum dots. Accordingly, in a preferred embodiment of the invention, there is an electronic band offset between the first and second colloidal quantum dots. Such an electronic band offset may arise from the presence of a type-I or type-II band alignments of the corresponding valence and conduction band levels of the first and second CQDs, and/or from the presence a different doping of the first CQDs compared to the second CQDs.

In some preferred embodiments of the invention, the first and second colloidal quantum dots are made of the same material. In the optional case that both the first and the second CQDs are made of the same material, this may advantageously facilitate the fabrication of the CQDs and of the thermistors comprising the CQDs, because it may allow for using similar or the same materials and methods for synthesizing and processing both the first and second CQDs. Therefore, the first and second CQDs may optionally differ from each other not in the semiconductor material from which they are made of, but in other features or characteristics of the CQDs such as their exact structure, morphology, size, diameter or surface chemistry. In some non-limiting examples, both the first and the second CQDs are made from lead sulfide (PbS) which is a semiconductor material, but the diameters of the first PbS CQDs are smaller or larger than the diameters of the second PbS CQDs, which would result to the bandgap of the first PbS CQDs being different from the bandgap of the second PbS CQDs. In another non-limiting example, both the first and the second CQDs are made of PbS and have the same size or diameter, but have a different surface composition or passivation, in particular different organic or inorganic ligands passivating or being attached to the surface of the CQDs. It is noted that usually the surface of CQDs is at least partially covered with organic or inorganic materials, such organic or metalorganic moieties or ligands, atoms or ions, and the exact coverage and composition of the surface of the CQDs may be controlled during the synthesis or post-synthesis processing of the CQDs. These ligands may affect significantly the electronic properties of the CQDs, such the doping concentration of the CQDs. Also, these ligands may affect significantly the position of the energy levels (e.g. the Ev, Ec and $E_F$) of the CQDs with respect to the vacuum zero energy level. Therefore, the first and the second CQDs may be passivated with different ligands which may cause or contribute towards the first and the second CQDs exhibiting different doping and different energy levels compared to each other. Hence, optionally the first and the second CQDs may optionally be covered with different ligand materials which may cause the properties of the first CQDs to differ from the respective electronic properties of the second CQDs, such that the resistivity of the layered structure and the overall performance of the device comprising these CQDs is advantageously benefited from the presence of a difference in the properties of the first and second CQDs. Hence, in some preferred embodiments of the invention, the at least one first layer comprises a first ligand material attached to the first colloidal quantum dots, and the at least one second layer comprises a second ligand material which is attached the second colloidal quantum dots and is different from the first ligand material.

Optionally and preferably, the first CQDs and/or the second CQDs comprise any of metal chalcogenide CQDs such as CQDs comprising PbX, $Ag_2X$ or HgX, where X=S, Se, Te and combinations thereof), III-V CQDs such as CQDs comprising InAs, InSb, GaAs, GaSb, InP, GaP and alloys thereof (e.g. InGaAs, InGaSb, InGaAsP etc.), or any other solution processed quantum dot material.

In a preferred embodiment of the invention, the first colloidal quantum dots differ in size and/or bandgap than the second colloidal quantum dots. These optional features may advantageously cause the formation of a band offset or doping difference between the first and second CQDs or the respective layers comprising the CQDs, which as described further above may advantageously result to an improvement and optimization of the performance of the thermistor.

In a preferred embodiment of the invention, the at least one first layer and the at least one second layer are arranged alternately in the layered structure such that each of the at least one first layer contacts a corresponding one of the at least one second layer. In the latest case, the alternate arrangement of the at least one first layer and the at least one second layer may advantageously result to the formation within the layered structure of an electronic band structure which may impact the Ea, TCR and resistivity of the layered structure, and may benefit the performance of the thermistor. A particular type of electronic band structure that may be formed by an alternating arrangement and, hence, the stacking of top of each other of the at least one first layer and the at least one second layer is a potential barrier (PB) structure. Said potential barrier structure may be formed in the optional and preferable case that the first and second layers are arranged alternately as mentioned above, and the respective layers or the CQDs comprised in these layers exhibit, with respect to each other, a band alignment which would cause that one layer of a particular type (i.e. a first layer or a second layer) sandwiched between two other layers of a different type, can act as quantum well layer in which charge carrier can be confined. For example, in the hypothetical case that the layered structure comprises at least two first layers, and at least one second layer which is sandwiched between the first layers and has a smaller bandgap than the first layers and forms with the latter a type-I or type-II band structure, then the second layer may act as a quantum well for one type of charge carriers. In the latter case, it can be understood that the successively arranged layers form potential barriers (PB) structures which can modulate and affect the $E_a$ and the TCR of the device. The modulation of $E_a$ allows tuning of the TCR but also affects the resistivity, and thus can provide an efficient way of controlling the properties of the thermistor. Confining charge carriers by employing PB structures is an efficient way of achieving this. In such a structure, the charge carriers are activated from a lower energy level of a quantum well layer to the PB energy level by the temperature. Such a structure can be formed by stacking different bandgap materials on top of each other and then repeating them to get the stack. This type of geometry employs a through-film current conduction and thus advantageously enables the fabrication of high-TCR thermistors and helps in maintaining a low resistance of the pixel to avoid impedance mismatch with ROICs. Hence, in a very preferred embodiment, the at least one first layer and the at least one second layer are configured to form at least one potential barrier structure.

The at least one first and the at least one second layers comprise the first and second CQDs respectively, but they may optionally comprise additional materials, e.g. organic or organic materials located in the space between the CQDs. Such additional materials if present may serve various purposes such as passivating or protecting the CQDs, modifying the electronic properties of the CQDs and of the layer, improving the adhesion between the layers, modifying any other properties (e.g. electronic, mechanical etc.) of the layers, improving a property or the stability of the device. It is also noted that in at least some cases, the CQDs may be passivated with materials, specifically organic or inorganic ligands, which are attached to the surface of the CQDs and, hence, may be considered as being a part of the CQDs and not as a separate material. Hence, it is possible that any of the first and the second layers of the device (i.e. of the thermistor) is primarily or completely made of CQDs arranged such that they form a colloidal quantum dot solid. Typically, in a CQD solid the CQDs are close packed together. However, even when in a CQD solid the CQDs are closely packed together there may still be gaps between the CQDs, and these gaps may be filled with air or other organic or inorganic matter.

In a preferred embodiment of the invention, the at least one first layer and/or the at least one second layer are a respective semiconductive colloidal quantum dot solid. Preferably, said respective semiconductive colloidal quantum dot solid has a majority carrier concentration of $10^{18}$ cm$^{-3}$ or more at a temperature of 300 K. More preferably, said respective semiconductive colloidal quantum dot solid has a majority carrier concentration of $10^{19}$ cm$^{-3}$ or more at a temperature of 300 K. Also, in some very preferred embodiments, the first quantum dots have a lower bandgap (i.e. smaller bandgap) compared to the second quantum dots, and the at least first layer which comprises or is made of said first quantum dots is heavily doped, i.e. has a majority carrier concentration of $\geq 10^{18}$ cm$^{-3}$ or, most preferably, $\geq 10^{19}$ cm$^{-3}$ at a temperature of 300 K. Making any of all of the first and second layers in the form of CQD solids, i.e. layers or films formed by the arrangement and packing of CQDs, may facilitate and simplify the fabrication of the overall device, because it allows to avoid making the layers from complex composite materials, and also because there are known solution-based methods for the fabrication of high-quality CQD solid films and layers with tailored properties. Such a property is the CQD solid's majority carrier concentration which depends on the doping of the CQDs and affects the resistivity and other electronic and optoelectronic properties of the CQDs and of the CQD solid. Advantageously, in the optional case that the CQDs forming a corresponding CQD solid (i.e. CQD layer) of the device are heavily doped such that the majority carrier concentration of the solid/layer is $\geq 10^{18}$ cm$^{-3}$ or $\geq 10^{19}$ cm$^{-3}$ at a temperature of 300 K, this may advantageously significantly improve the conductivity of the layer, and thus may result to an efficient charge conduction through the layer during an operation of the device, thereby improving the conductivity and the overall performance of the device. It is noted that typically increasing the conductivity of the thermistor results to improving the performance of the device (i.e. of the thermistor) via lowering the noise and improving the detectivity of the device. Moreover, in the optional case that the aforementioned CQD solid is heavily doped, e.g. has a majority carrier concentration of $\geq 10^{18}$ cm$^{-3}$, then this for at least some CQD materials may advantageously enable the possible occurrence of intra-band carrier transitions in the CQDs via the excitation of free charge carriers in the valence band ($E_{VB}$) or conduction band ($E_{CB}$) of the CQDs by infrared photons, particularly mid-wave IR (MWIR) or long-wave IR (LWIR) photons. This may advantageously allow for the use of CQD layer/solid as a direct absorber of MWIR or LWIR radiation, and this can be particularly useful in the optional case that the thermistor is part of another device, particularly a bolometer or image sensor, used for the detection or measurement of said MWIR or LWIR radiation.

In a preferred embodiment of the invention, the layered structure at a temperature of 300 K and under the application of a voltage of between 0.1 and 1 V (volt) between the two electrodes is configured to have a negative temperature coefficient of resistance, TCR, the absolute value of which is equal to or more than 1 %/K, preferably equal to less or more than 3 %/K, more preferably equal to less or less more than -5 %/K. In the optional case that the interlayer structure presents the aforementioned TCR values, and especially when the absolute value of the TCR is $\geq 3$ %/K or $\geq 3$ %/K, then advantageously the performance of the thermistor is comparable or better than many conventional types of thermistors of the prior art. It is noted that as mentioned further above, The TCR is defined as the change in resistance per unit change in temperature, typically expressed as a percentage per degree Kelvin by the equation 1 shown further above.

The thermistor of the first aspect of the invention or the layered structure of the thermistor may optionally comprise additional layers to the ones mentioned further above. For example, the thermistor may comprise one or more additional layers arranged between any of the two electrodes and the layered structure, or located between any of the at least one first and at least one second layers of the layered structure, or located on any of the two electrodes or elsewhere at the device. Such an optional additional layer may serve one or more functionalities, such as for example improving the electrical contact between different layers, improving the adhesion of the layers, improving the thermal contact between layers or acting as a thermal insulation between layers or between the device and the environment, improving the mechanical properties or stability of the device, protecting the device or a layer therein from the environment, improving the stability of the device, protecting the device or layers therein from environmental factors such as humidity, oxygen etc.

The present invention in a second aspect concerns a bolometer which comprises a thermistor of the first aspect of the invention. Said bolometer is a device that may be used for measuring radiant heat, i.e. thermal radiation, especially for measuring thermal radiation in the infrared (IR) spectrum. For this reason, in some preferred embodiments of the second aspect of the invention, the bolometer further comprises an absorber which is configured to absorb infrared radiation and convert at least part of the absorbed radiation into heat, wherein the absorber is integrated with the layered structure, or the absorber is in thermal contact with the layered structure of the thermistor. Said thermal contact may serve for transferring to the layered structure and the layers therein heat that may be produced at the absorber by the absorption of the radiation. The transferred heat may cause a change of the temperature of the layered structure, which may in turn cause the change in the resistivity of the layered structure, and this change of the resistivity may be measured via the application of bias voltage across the two electrodes. Similarly, if the absorber is integrated with the layered structure, the heat produced by the absorption of the infrared radiation by the absorber may be passed to the layered structure causing a change in the layered structure's resistivity.

The aforementioned absorber may comprise or be made of one or more materials suitable for absorbing the IR radiation, and preferably for absorbing MWIR and/or LWIR radiation. These materials may be metals, conductors or semiconductors. Some non-limiting examples of such materials are silicon nitride and titanium nitride. Also, the absorber may comprise CQDs configured to absorb in the IR, e.g. in the near IR, MWIR or LWIR, and these CQDs may be heavily doped CQDs and configured to exhibit intra-band absorption in the IR. It is noted that if the absorber comprises CQDs the latter may be the same as the first or second CQDs of the layered structure, or maybe of the same or of a different type of CQDs compared to the first and second CQDs. Hence, in some preferred embodiments of the second aspect of the invention, wherein the thermistor comprises the aforementioned absorber, the latter comprises any of a silicon nitride, titanium nitride, or colloidal quantum dots which preferably are heavily doped CQDs, more preferably the majority carrier concentration of said heavily doped CQDs being $\geq 10^{18}$ cm$^{-3}$ or even $\geq 10^{19}$ cm$^{-3}$.

In some preferred embodiments where the thermistor comprises the aforementioned absorber, the latter comprises at least part of the layered structure, e.g. the at least one first layer, or the at least second first layer. Hence, in some preferred embodiments the absorber may comprise at least some of the integrated structure, and in particular may comprise at least some of the at least one first layer and/or the at least one second layer. In the latter case, if in addition the first and/or the second CQDs of the respective first and/or second layers are configured to absorb infrared radiation, then they may contribute to the absorber's function of capturing infrared radiation and converting it to heat. For at least some types of CQDs, such as for example PbS CQDs, one mechanism via which the CQDs may absorb IR is via an intra-band excitation of charge carrier in the CQDs. Accordingly, in some preferred embodiments of the invention, the first and/or the second colloidal quantum dots are configured to infrared radiation, preferably via intra-band excitation of charge carriers in the colloidal quantum dots.

In a preferred embodiment of the second aspect of the invention, herein referred to as the "exemplary" embodiment, the bolometer comprises the aforementioned absorber, and the latter (i.e. the absorber) is a layered plasmonic metamaterial absorber which is configured to resonantly absorb the mid- and/or long-wavelength infrared radiation and comprises a metallic base layer, a metamaterial pattern and an optical spacer which is arranged between the metallic base layer and the metamaterial pattern, preferably the optical spacer comprising colloidal quantum dots, more preferably the layered structure of the thermistor forming the optical spacer. It is noted that in the latter case, said colloidal quantum dots of the spacer may optionally be of the same type (i.e. have the same characteristics) as the first and/or the second CQDs, or may be a different type of CQDs. However, it is noted that if the CQDs of the spacer are of the same type as the first and/or the second CQDs, this may allow for simplifying the fabrication of the device.

In the aforementioned exemplary embodiment, the absorber which comprises the metamaterial structure may be considered as being a metal-insulator-metal based plasmonic metamaterial absorber (MIM-PMA). A MIM-PMA typically is a type of thin-film plasmonic structure, where a dielectric layer is sandwiched between the two metallic layers. The metallic base layer of the MIM-PMA may also be called bottom metallic layer or ground plate, the metamaterial pattern preferably is made of metal and is called top metallic layer, and the optical spacer can be considered as being dielectric layer. Typically, in a MIM-PMA, the metal pattern layers may serve as antennae to receive the EM radiation and interact with it, while the dielectric layer may confine the electromagnetic (EM) energy in the structure. When incident radiation strikes the upper metallic layer, the lower metal layer may function as a mirror, reflecting the surface plasmon generated at the lower metal-insulator interface. The destructive interference of this surface plasmon between the upper and lower metal-insulator interfaces may give rise to resonant modes within the dielectric cavity. As a result, the radiation may become confined and absorbed. The resonant frequency or the frequency of maximum absorption can be easily tuned for such a structure by changing the geometry and material of the metal layers and also of the dielectric layers. The thickness of the bottom metal plate is preferably kept higher than the skin depth to prevent transmission.

The aforementioned dielectric layer may preferably be made of one or more common materials which include Si, Ge, $Al_2O_3$, $Si_3N_4$, $SiO_2$, etc. The advantages of such materials are that they are readily deposited and have a mature technology to facilitate tuning and compatible fabrication with current CMOS technology. However, the deposition methods that are required for the deposition of such dielectrics may be power-consuming and sophisticated, and sometimes require placing the samples for prolonged periods at higher temperatures to achieve a required thickness. Consequently, to simplify the full fabrication process for a bolometer device that includes the aforementioned MIM-PMA, preferably the optical spacer (i.e. the dielectric layer) of the device comprises colloidal quantum dots, more preferably said colloidal quantum dots being of the same type(s) as the first and/or the second CQDs of the layered structure, most preferably the layered structure of the thermistor forming the optical spacer. The use of CQDs in the optical spacer may simplify the fabrication of the overall device, because the CQDs can be synthesized and processed into forming layers and thin films via simple, scalable and accurately controlled solution-based methods which may be more cost-effective and less energy consuming compared to a lot of methods used for the growth of conventional dielectric materials.

In a preferred embodiment of the invention, the thermistor further comprises a substrate which comprises an air bridge which supports the thermistor which is on the air bridge. The air bridge may simply be called "bridge" and may advantageously serve for suspending the thermistor over vacuum for the purpose of minimizing the thermal coupling of the thermistor with the rest of the substrate. This may beneficially allow for minimizing the thermal loss that may occur from a transfer of heat from the thermistor to the substrate, and for maximizing a signal and improving the detectivity of the device. Minimizing the thermal coupling between the thermistor and the rest of the substrate may be particularly important in the optional case that the substrate is part of a larger device such as an image sensor that may comprise an array of thermistors, bolometers or other electronic components which may be heated or may generate heat during an operation of the device.

The invention in a third aspect concerns an image sensor comprising a plurality of pixels, wherein each pixel comprises a respective bolometer of the second aspect of the invention. Said image sensor is preferably a heat or IR camera, more preferably a MWIR or LWIR camera.

It may be understood that any optional or preferable features mentioned herein with respect to the first aspect of the invention, may correspond to respective optional or preferable features of any of the second or third aspects of the invention, and vice versa.

Additional advantages and features of the invention will become apparent from the detailed description that follows and will be particularly pointed out in the appended claims.

## BRIEF DESCRIPTION OF THE DRAWINGS

To complete the description and in order to provide for a better understanding of the invention, a set of drawings is provided. Said drawings form an integral part of the description and illustrate embodiments of the invention, which should not be interpreted as restricting the scope of the invention, but just as examples of how the invention can be carried out. The drawings comprise the following figures:

Fig. 1A illustrates a schematic cross section of a preferred embodiment according to the first aspect of the invention.

Fig. 1B illustrates a perspective view of the embodiment of Fig. 1A.

Fig. 2A illustrates a schematic cross section of a preferred embodiment according to the first aspect of the invention.

Fig. 2B illustrates a potential energetic distribution in a structure of the embodiment of Fig. 2A.

Fig. 3 illustrates a band diagram of a PB structure with large bandgap material as the barrier layer.

Fig. 4 illustrates a schematic cross section of a preferred embodiment according to the second aspect of the invention.

Fig. 5 illustrates a top view of the embodiment of Fig. 4.

Fig. 6 illustrates a schematic cross section of a preferred embodiment according to the second aspect of the invention.

Fig. 7 illustrates a top view of the embodiment of Fig. 6.

Fig. 8 illustrates a schematic cross section of a preferred embodiment according to the second aspect of the invention.

Fig. 9 illustrates a schematic cross section of a preferred embodiment according to the second aspect of the invention.

Fig. 10A illustrates a schematic cross section of a preferred embodiment according to the second aspect of the invention.

Fig. 10B illustrates a schematic cross section of a preferred embodiment according to the second aspect of the invention.

Fig. 11 illustrates a) a structure of some thermistor devices according to the invention, and b) the normalized resistance of the devices with varying widths of the PB.

Fig. 12 illustrates (left) a schematic of a bolometer device with a QDs-based thermistor and a MIM-PMA, and (right) an SEM image of the device.

Fig. 13 illustrates optoelectronic characterization data of the device of Fig. 12.

Fig. 14 illustrates a schematic cross-section and an SEM image of one of the pixels of a bolometer device which has a different geometry compared to the device of Fig. 12.

Fig. 15 illustrates optoelectronic characterization data of the device of Fig. 14.

## DESCRIPTION OF A WAY OF CARRYING OUT THE INVENTION

The following description is not to be taken in a limiting sense but is given solely for the purpose of describing the broad principles of the invention. Next embodiments of the invention will be described by way of example, with reference to the above-mentioned drawings, showing embodiments according to the invention.

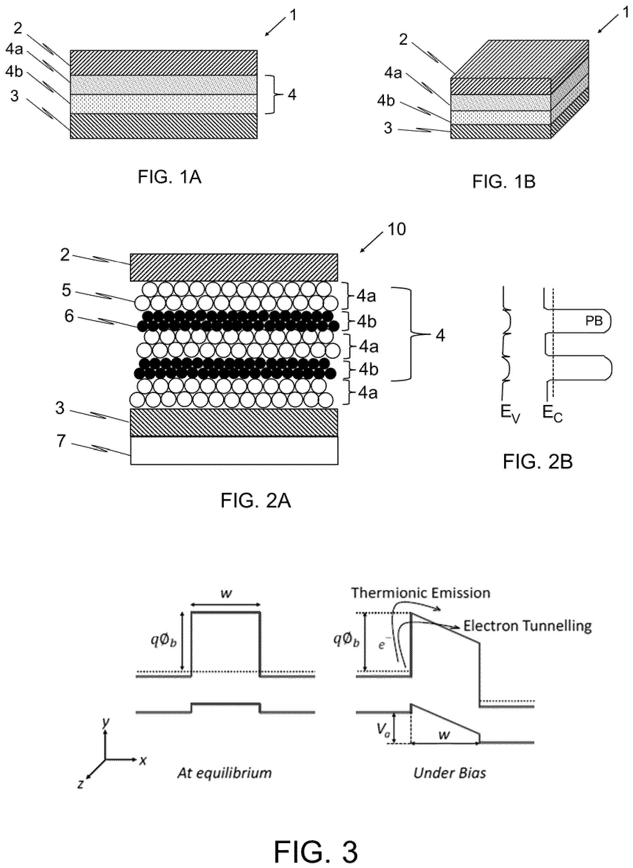

A preferred embodiment of a thermistor according to the first aspect of the invention is explained next with reference to Fig. 1A and Fig. 1B. The thermistor 1 of Fig. 1A is a device which comprises a first electrode 2, a second electrode 3 and a layered structure 4 which is in contact with the two electrodes. The layered structure 4 of the embodiment of Fig. 1A and Fig. 1B comprises a first layer 4a which comprises first colloidal quantum dots, and a second layer 4b which comprises second colloidal quantum dots which differ from the first colloidal quantum dots.

Another preferred embodiment of a thermistor according to the first aspect of the invention is explained next with reference to Fig. 2A and 2B. Fig. 2A illustrates a thermistor 10 which is according to the embodiment of Fig. 1. Moreover, the thermistor of Fig. 2A comprises a substrate 7, and the layered structure 4 which is sandwiched between the first electrode 2 and the second electrode 3 comprises three first layers 4a and two second layers 4b. Also, in the device of Fig. 2A, the first layers 4a and the second layers 4b are arranged alternately such that each second layer 4b contacts a corresponding one of the first layers 4a. Moreover, in the embodiment of Fig. 2A, each of the first layers 4a is a respective first colloidal quantum dot solid comprising first colloidal quantum dots i.e. colloidal quantum dots (CQDs) of a first type, and each of the of the second layers 4b is also a respective second CQD solid comprising second CQDs i.e. CQDs of a second type. The first CQDs and the respective first layers have a band offset with respect to the second CQDs and the respective second layers, and Fig. 2B illustrates a potential energetic distribution in the stack which is formed by the first and the second layers 4a, 4b in the thermistor 10. Such a potential energetic distribution may be determined via photoelectron spectroscopy. In the embodiment of Fig. 2A, at equilibrium, the valence band edge $E_v$ (valence band edge energy level) and the conduction band edge Ec (conduction band edge energy level) of the first layers is offset with respect to the corresponding energy levels of the second layers, such that each of the second layers acts as a potential barrier (PB) that may hinder the crossing, along the thickness of the stack, of electrons. Due the presence of the potential barriers shown in Fig. 2B, the thermistor of Fig. 2A may also be called quantum dot potential barrier-type (QBPT) thermistor, and a stack, i.e. a layered structure, comprising one or more PBs as the ones shown in Fig. 2B may be called QBPT stack or QBPT structure. The charge transport mechanism through such a structure may be explained through an approximate energy band structure which is shown in Fig. 3. Assuming a small applied bias of $V_a$ across the PB, few electrons can attain enough energy to cross the barrier as a result of thermal activation. This thermal activation of charge carriers may be mainly governed by the potential barrier height $q\varnothing_b$, which may also define the activation energy for transport. As $V_a$ is increased, the potential barrier may tilt and the electrons rising in energy may find the PB width varying. In this scenario, some more electrons can cross the PB via tunnelling through the reduced barrier width at the top of the barrier. This tunnelling of charge carriers through the reduced barrier width may result in a reduction of $E_a$ with increasing bias and may lead to the bias dependence of $E_a$ and hence TCR for such structures. Also, for such a PB structure, the TCR may depend on various parameters such as the barrier height, the barrier width and the bias applied. Moreover, the number of PB layers may affect the performance of similar structures due to the confinement of an increasing number of charge carriers contributing to charge transport. Therefore, in such structures, the charger carriers must cross the PB for conduction, which provides an efficient way of controlling $E_a$ for the transport of carriers, and hence the TCR of the structure. It is noted that although in the embodiment of Fig. 2A the layered structure comprises two PB structures, in some other preferred embodiments of the invention which are similar to the one of Fig. 2A, the layered structure of the thermistor comprises one or more than two PB structures. Also, in some other preferred embodiments of the invention which are similar to the one of Fig. 2A, the layered structure of the thermistor comprises different numbers of first and second layers compared to ones of the thermistor of Fig. 2A.

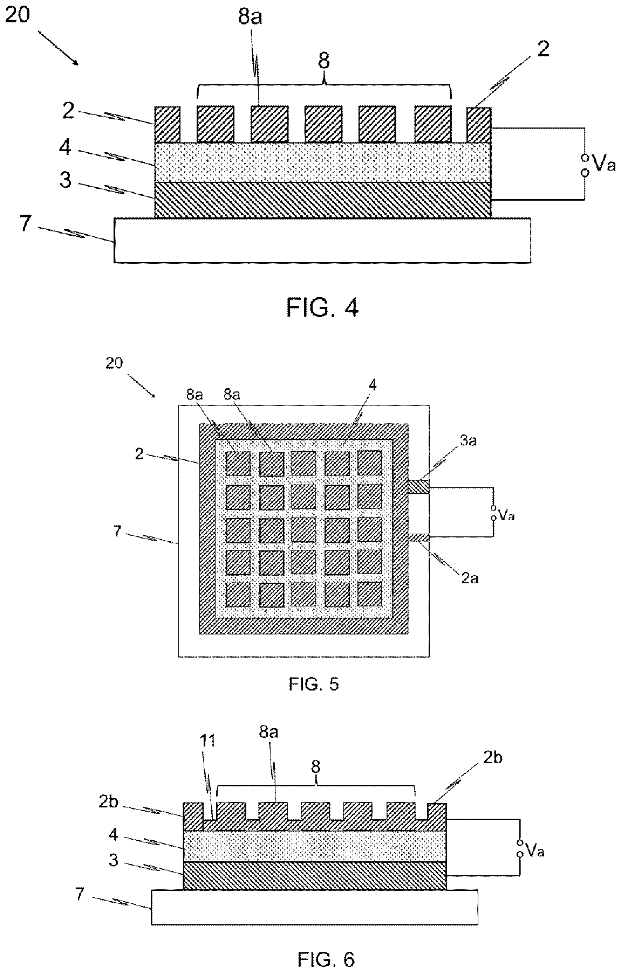

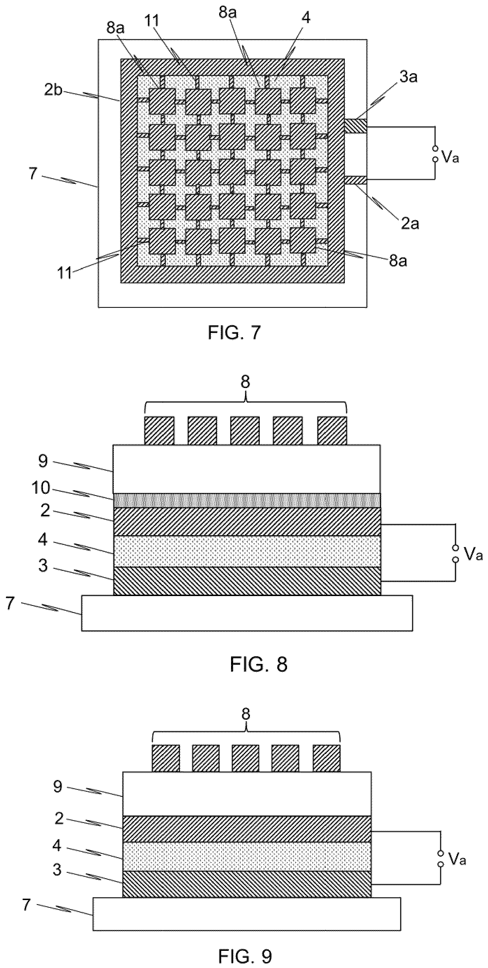

A preferred embodiment according to the second aspect of the invention is explained next with reference to Fig. 4 and 5. Fig. 4 and Fig. 5 illustrate a bolometer 20 which comprises a thermistor which is according to the first aspect of the invention. Hence, the bolometer of Fig. 4 comprises a layered structure 4 and two electrodes 2, 3. In the embodiment of Fig. 4 the two electrodes are located on respective opposite sides of the layered structure 4 which is in contact with the two electrodes. Hence, the first electrode 2 is on a first side of the layered structure 4, and the second electrode 3 is on a second side of the layered structure. Also, in the embodiment of Fig. 4 and Fig. 5 the first electrode 2 has the form of a square-shaped ring, and the second electrode 3 has the form of a square. Also, the bolometer 20 of Fig. 4 comprises a substrate 7 on which the thermistor has been formed, with the second electrode 3 being between the layered structure 4 and the substrate 7. Also, on the substrate of Fig. 7 there are formed a first conduction channel 2a in contact with the first electrode 2, and a second conduction channel 3a in contact with the second electrode 3. The channels 2a, 3a may be used for the application of an electrical bias (voltage) $V_a$ across the two electrodes 2, 3, and more generally for performing electrical measurements. Also, in the embodiment of Fig. 4 and 5 the bolometer 20 comprises a layered plasmonic metamaterial absorber (PMA) which is configured to resonantly absorb infrared radiation. The absorber of the embodiment of Fig. 4 and Fig. 5 comprises a metallic base layer which is the second electrode 3, a metamaterial pattern 8 which is formed by an array of metallic square blocks 8a which are on the first side of the layered structure 4 and are surrounded by the ring-shaped first electrode 2. Also, in the embodiment of Fig. 4 and Fig. 5 the layered structure acts as an optical spacer which is arranged between the metallic base layer and the metamaterial pattern 8 of the layered plasmonic metamaterial absorber. Hence, it may be understood that in the embodiment of Fig. 4 and Fig. 5, the layered structure of the thermistor forms the optical spacer, and the latter comprises the first and the second colloidal quantum dots of the layered structure.

Another preferred embodiment according to the second aspect of the invention is explained next with reference to Fig. 6 and 7. The bolometer of Fig. 6 and Fig. 7 is similar to the embodiment of Fig. 4, but differs compared to the latter embodiment as follows. In the embodiment of Fig. 6 the square blocks 8a of the metamaterial structure 8 are electrically connected with each other and with a square-shaped ring 2b, via conductive channels 11. The square-shaped ring 2b surrounds the square blocks 8a on the first surface of the layered structure where the blocks 8a are located. In the embodiment of Fig. 7 the metallic square blocks 8a, the square-shaped ring 2b and the conductive channels 11 are made of the same metallic material and form the first electrode of the device.

Another preferred embodiment according to the second aspect of the invention is explained next with reference to Fig. 8. Fig. 8 illustrates a bolometer which comprises a thermistor which is according to the first aspect of the invention. Hence, the bolometer of Fig. 8 comprises a layered structure 4 and two electrodes 2, 3 which are in electrical contact with the layered structure and are located on respective opposite sides of the layered structure 4. Also, in the embodiment of Fig. 8 the first electrode 2 is a first conductive layer (i.e. first electrically conductive layer) formed on a first surface of the layered structure 4, and the second electrode 3 is a second conductive layer (i.e. second electrically conductive layer) formed on a substrate 7 such that the second electrode 3 is between the substrate 7 and the layered structure 4. The embodiment of Fig. 8 also comprises an absorber which is configured to absorb infrared radiation and convert at least part of the absorbed radiation into heat. More specifically, the absorber of the embodiment of Fig. 8 is a layered plasmonic metamaterial absorber which is configured to resonantly absorb the mid- and/or long-wavelength infrared radiation, and for this purpose comprises a metallic base layer 10, a metamaterial pattern 8 and an optical spacer 9 which is arranged between the metallic base layer 10 and the metamaterial pattern 8. Said optical spacer is preferably made of or comprises any of a high refractive index material (e.g. a material with a refractive index of >1.5), CQDs, Si, Ge, $Al_2O_3$, $Si_3N_4$, or SiOz. In the embodiment of Fig. 8, heat that may be generated in the absorber via the absorption of infrared radiation, can be transferred to the layered structure 4 via the first electrode 2 which is between the metallic base layer 10 and the layered structure 4. Hence, in the embodiment of Fig. 8, the first electrode 2 acts as a thermal contact between the absorber the layered structure 4.

Fig. 9 shows another preferred embodiment of the second aspect of the invention. The embodiment of Fig. 9 comprises a layered plasmonic metamaterial absorber and is similar to the embodiment of Fig. 8. However, in the embodiment of Fig. 9 the first electrode 2 of the device acts as the metallic base layer of the absorber.

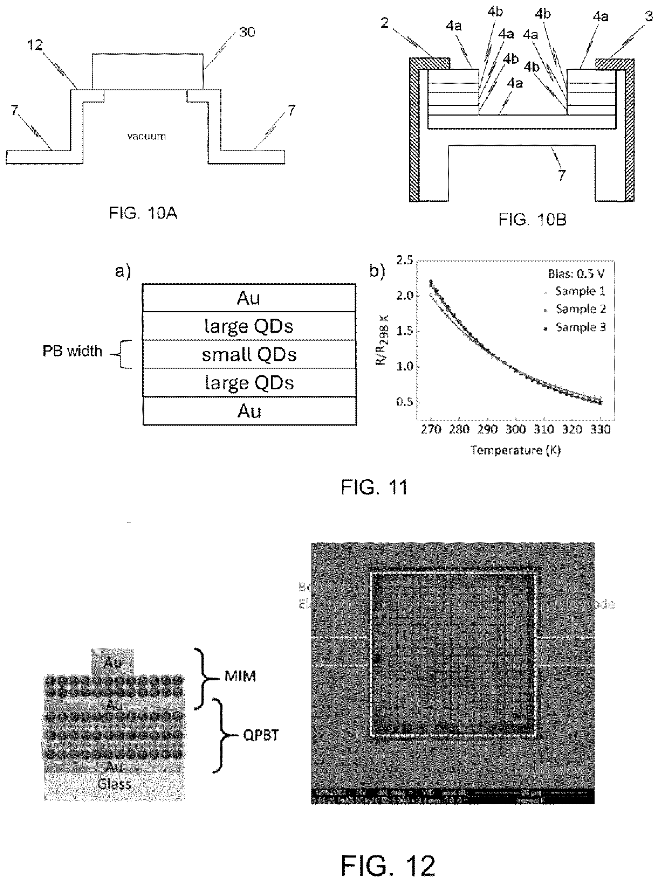

Another preferred embodiment according to the second aspect of the invention is explained next with reference to Fig. 10A. In the embodiment of Fig. 10 a part 30 of the bolometer is on an air bridge 12 of a substrate 7 of the bolometer, and said part 30 includes a thermistor which is according to the first aspect of the invention. Also, in the embodiment of Fig. 10A, this air-bridge suspends the thermistor over vacuum.

Another preferred embodiment according to the second aspect of the invention is explained next with reference to Fig. 10B. In the embodiment of Fig. 10B, the bolometer comprises a substrate 7 and a thermistor which is according to the first aspect of the invention and is on an air-bridge of the substrate. This air-bridge, which may also be called bridge, suspends the thermistor over vacuum or a gaseous atmosphere, depending on the method used for preparing or processing the device. In the bolometer of Fig. 10B, the thermistor comprises two electrodes 2, 3 and a layered structure which comprises first layers 4a and second layers 4b which are arranged as illustrated by Fig. 10B. The two electrodes are located on opposite ends of the bridge, and the layered structure connects these two opposite ends such that during an operation of the thermistor charge carriers may pass from one electrode to the other via a path formed by the first and second layers which are alternately arranged along said path. Preferably, the substrate 7 or at least a part of the substrate where said bridge is formed, comprises silicon oxide and/or silicon nitride. Said silicon oxide and/or silicon nitride may preferably be in the form of respective layers formed on a silicon wafer. Hence, the substrate may preferably comprise a silicon layer. In the embodiment of Fig. 10B, the substrate 7 is made of silicon oxide and silicon nitride. It is noted that preferably the bridge suspends the thermistor over vacuum, and said vacuum may be created by sealing the bolometer under vacuum.

In relation to the present invention, the following sets of experiments were performed.

First set of experiments

To study the size-dependent thermistor properties of CQDs, some devices were prepared on a SiOz (285 nm)/p$^+$-Si (< 0.005 $\Omega$ cm) wafer. The wafer was diced in square pieces of 10 mm $\times$ 10 mm and cleaned thoroughly in Acetone, Isopropanol, and DI water for 3 mins each using ultrasonication. The substrate pieces were then patterned with photolithography to form parallel Gold (Au) 40 nm/Titanium (Ti) 3 nm electrodes with finger width and separation of 10 $\mu$m each. The lead sulfide (PbS) CQDs were developed under an inert atmosphere using the hot injection method, as in reference [1]. The PbS CQDs dispersed in toluene with the help of Oleic acid ligands were then used to make thin films on the patterned substrates using the spin-coating technique with the following steps: 1) 50 $\mu$L solution of CQDs with 30 mg/mL concentration was dropped on the substrate and spun immediately at a speed of 2500 rpm for the 40 s; 2) a ligand exchange solution of 7 mg/mL of 1-ethyl-3-methylimidazolium iodide (EMII) in methanol was dropped on the coated film and left for 30 s to allow proper ligand exchange and QDs reorganization in the film [2]; 3) the film was then spun for 10 s before being washed by dropping methanol in the spinning condition to remove unwanted and unbounded ligand molecules; 4) above steps from 1) to 3) were then repeated until the desired thickness of the film was achieved; 5) the spin-coated films were then transferred immediately to an atomic layer deposition system for the deposition of 80 °C Al$_2$O$_3$ (Alumina). The low-density alumina infilling along with the I--ligand exchange may improve the conductivity by lowering the inter-QDs barrier width and height and thus enabling efficient charge conduction in the film.

The temperature-dependent electrical characteristics of the prepared devices were measured by taking the current-voltage (I-V) characteristics at different temperatures in the temperature range of 270-340 K, using a vacuum probe station equipped with a semiconductor analyzer and a temperature controller. An automated temperature measurement routine was created to operate and ample settling time (~12 mins) was provided between successive measurements to ensure a stable response from the device. The I-Vs of the devices were ohmic, implying the n-type behavior of the quantum dots (QDs) treated with EMII and infilled with Alumina. In the devices of this set of experiments, as there is no additional potential barrier (PB) to overcome in an ohmic device, the activation energy for the transport i.e., $E_a$ is solely governed by the electronic structure of the QDs and the electric potential variations due to the QDs surroundings (such as ligand barrier, polydispersity, etc.). Moreover, the quality of the film was studied with scanning electron microscopy (SEM), and the results of the study further strengthened the idea of $E_a$ being predominantly dependent on the QDs itself and not on the external factors such as the morphological disorders (e.g. cracks) in the film that may affect charge transport in the film.

According to the performed measurements, the QDs exhibit a typical semiconducting behavior where the resistance/resistivity decreases exponentially as a function of temperature according to the following equation:

$$\rho = \rho_0 \exp\left(\frac{E_a}{kT}\right) \qquad \text{(equation 3)}$$

where $\rho$ is the resistivity in $\Omega$ cm, $\rho_0$ is a pre-exponential factor depending on the material parameters such as mobility and density of states, $E_a$ is the activation energy for the transport of charge carriers in eV, $k$ is the Boltzmann constant in eV/K, and T is the temperature in K.

The activation energy for the transport and the corresponding TCR was then evaluated for several different sizes of QDs similarly, by keeping the ligand exchange and the alumina-infilling recipe fixed. To calculate resistivity, the thickness of the CQD films was measured by a profilometer, with 10 nm resolution. The QD size ranged from about 2.5 nm (QDs that exhibit a 751 nm exciton peak) to about 10 nm (2060 nm exciton peak). It was found that the resistivity of the films increases drastically and rather rapidly as it is reduced the size of the dots smaller than ~4.5 nm (1300 nm exciton peak). The results showed that the TCR shoots up for smaller dots, reaching to value of -4.62 %/K for the smallest studied QD at 295 K, with a resistivity of ~$6.92 \times 10^4$ $\Omega$ cm. For comparison with commercially used thermistor films, the typical resistivity of imaging-grade $VO_x$ films lies between 0.1 to 10 $\Omega$ cm with a TCR between -2 to -3 %/K and the resistivity increases for higher TCR values. In the case of the devices of this set of experiments, the TCR and resistivity values compete well with those of $VO_x$ films in the higher TCR regime as is the case for 751 nm exciton peak QDs (2.54 nm), but on comparison with the TCR range of the imaging-grade $VO_x$, the QDs studied in this first set of experiments have higher resistivity values. This comparison provides an insight into the use of PbS QDs as a thermistor material for bolometer technology, as it competes well with some commercially used thermistors in the high-TCR range. However, the high-TCR range is particularly useful for the through-film geometry, as in the through-film geometry the current flows across the thickness of the film, which is usually between 100-200 nm as compared to tens of micrometers in lateral geometry, so that the output impedance of the bolometer pixel doesn't get too high and cause an output impedance mismatch with the read-out integrated circuits (ROICs).

The noise behavior of the QDs of the fabricated devices was also studied. The noise current spectral density (NCSD) of the studied QDs, was evaluated by taking the Fast-Fourier-Transform (FFT) of the steady-state dark current at 295 K, under vacuum conditions. The analog-to-digital converter (ADC) integration factor was kept to one along with the sampling interval of 2 ms, the lowest for the semiconductor analyzer. It was found that the amplitude of the NCSD increases with the size of the QDs.

The 1/f noise can be expressed by Hooge's formula, and a 1/f parameter can be utilized for a comparison, such as:

$$S_I = \frac{a_H I_b^2}{fN} \qquad \text{(equation 4)}$$

Where $S_I$ is the noise current power spectral density (PSD) with units of $A^2$/Hz, $I_b$ is the bias current, and $a_H/N$ is the 1/f parameter where N is the number of charge carriers. From a plot of normalized PSD vs f, the 1/f parameter was determined at 1 Hz, which is summarized in Table 1 along with the different studied parameters for the PbS QDs:

**Table 1**

| QD Excitonic Wavelength (nm)/Materials | Size (nm) | $E_a$ (V) | Resistivity ($\Omega$ cm) | TCR (%/K) | 1/f Parameter |
|---|---|---|---|---|---|
| 751 | 2.54 | 0.3464 | 69234.58 | -4.62 | $1.3 \times 10^{-6}$ |
| 1100 | 3.68 | 0.1243 | 47.75 | -1.66 | $7.1 \times 10^{-9}$ |
| 1300 | 4.48 | 0.0536 | 6.675 | -0.71 | $3.3 \times 10^{-10}$ |
| 1500 | 5.45 | 0.0254 | 1.734 | -0.34 | $1.7 \times 10^{-12}$ |
| 1800 | 7.6 | 0.0277 | 0.72 | -0.37 | $7.5 \times 10^{-13}$ |
| 2068 | 10.10 | 0.0254 | 0.778 | -0.34 | $1.7 \times 10^{-13}$ |

Second set of experiments

In this second set of experiments, a QDs-based PB thermistor (QPBT) stack was developed using the layer-by-layer deposition by spin coating method which is described further above. Here, two different sizes of CQDs were employed, with smaller-sized dots acting as the PB layer and larger-sized dots as the potential well or the conducting layers. This configuration was utilized as the larger-sized dots have significantly higher electrical conductivity as compared to the smaller-sized dots, as discussed further above, which advantageously allowed for minimizing the total resistance of the QPBT pixel and also modulating the barrier height effectively.

To fabricate the structure, glass substrates were coated with ~10 nm 175 °C alumina in ALD and were subsequently patterned by lithography and metal evaporation to form Ti/Au electrodes in the form of 30 $\mu$m wide strips with relatively larger contact pads. During the spin-coating process, the larger-sized PbS dots were treated with EMII ligand and the already described procedure was followed to form a layer of suitable thickness. After that, smaller-sized PbS dots were spin-coated on top of it and were treated with either EMII (30 s) or 0.1 % solution of 3-Mercaptopropionic acid (MPA) in methanol for 12s. The films were then rinsed in the spinning state with methanol to remove unbounded ligand molecules. The above procedure was repeated to get the required thermistor stack with a defined number of PB layers. The films were then infilled with 80 °C alumina as described earlier, to get the thermistor stack constituting robust CQDs films in layer-by-layer fashion. To form the top electrode, the samples were again patterned with lithography and 40-50 nm Au was thermally evaporated and subsequently lifted off to make pixels of 30 × 30 μm size.

It was observed that the developer solution used for the development of photoresist during the lithography process contains a chemical called tetramethylammonium hydroxide (TMAH), which is also capable of dissolving alumina. The dissolving rate however varies depending on the concentration of the TMAH solution and the density of alumina. The integration of the two steps: photoresist development and alumina etching, was then performed by observing the development process under the microscope and testing the device after different development times. It was observed that development for a few tens of seconds more than the normal development time results in the removal of the QDs as the TMAH attacks the infilled alumina as well as the QDs.

Several control devices were then tested after etching the alumina with TMAH during the photoresist development step for an optimized time ensuring that the TMAH doesn't attack the infilled alumina significantly. This method enabled the fabrication of QPBT stack devices reproducibly.

Three devices were fabricated. These devices were used for evaluating the effect of PB width on the performance of QPBT by changing the number of spin-coated layers for the smaller QDs, keeping the concentration of the QDs solution fixed at 30 mg/mL, the spin-coating speed to 2000 rpm for 850 nm exciton peak PbS QDs, and the ligand exchange solution to be EMII. The structure each of the three devices is illustrated in a) of Fig. 11, and the thickness of each of the large QD layers was about 40 nm. With this configuration, the expected thickness of the PB layer was estimated by profilometry to be around ~13 nm for one layer. The first device is named Sample 1:222, the second device is named Sample 2: 232, and the third device is name Sample 3: 242. The sequence corresponding to the sample number represents the spin-coating sequence followed during the fabrication of the devices and the numbers represent the number of layers coated, such that the middle number in the sequence, say 232, signifies that 3 layers of small-sized dots were sandwiched between 2 layers of large-sized dots each on top and bottom to prepare the PB structure. In each of the three devices, the two electrodes are made of gold (Au). The I-V (current-voltage) characteristics of the devices were measured, and the normalized resistance for the three devices is illustrated in b) of Fig. 11. Also, Table 2 summarizes some important details of the three devices (samples):

**Table 2**

| Sample | PB Width (nm) | $E_a$* (V) | TCR* (%/K) |
|---|---|---|---|
| Sample 1: 222 | ~26 | 0.16815 | -2.2 |
| Sample 2: 232 | ~39 | 0.19052 | -2.54 |
| Sample 3: 242 | ~52 | 0.19506 | -2.61 |
| *values corresponding to 295 K | | | |

The effect of the number of PB layers on the QPBT performance was also investigated. For this reason, two samples, one with a single potential barrier (SPB), and the other with a double potential barrier (DPB) layers were fabricated following the processes and methods mentioned further above, and the two samples were tested for evaluating their temperature-dependent performance. In these two samples, the PB thickness is similar to that of sample 2 (Table 2), while the thickness of the conduction layer was reduced to one spin-coated cycle i.e. to ~20 nm. The I-V characteristics of the devices for different temperatures were measured, and it was found that the inclusion of another PB layer in the device results in an approximately twofold increase in the resistance of the pixels. However, the pixel resistance is not very high and remains suitable for integration with ROIC technology. This increase in the resistance has been accompanied by an enhanced $E_a$ for the DPB devices. As a result, the TCR for the DPB device comes out to be significantly higher than the SPB device, resulting in a more efficient QPBT structure with enhanced TCR for increased sensitivity. Hence, for an applied volage of between 0.1 and 1V and for a temperature between 280 to 340 K, the DPB device exhibited a TCR of more than 2 %/K.

The performance was further optimized by modifying the height of the PB via modifying the ligands of the QDs. To do this, the ligand exchange solution of smaller-sized dots was changed from EMII to MPA, while keeping EMII as the ligand solution for the larger-sized dots. The ligand exchange solution of the smaller-sized dots was prepared by mixing MPA and methanol in the desired volume to get a 0.1 % (v/v) solution of MPA in Methanol. The other parameters such as the concentration of CQDs, spin-coating parameters, and the alumina etching process and electrode formation were kept unchanged. Two types of devices were fabricated. To make identification of the devices, the devices fabricated with only one type of ligand are called Homo-ligand (HoLi) devices, and the devices fabricated with different types of ligands are called Hetero-ligand (HeLi) devices. For such comparison, the DPB devices were fabricated with the same size of dots as described in the previous section, but the PB barrier width was kept equivalent to two spin-coated layers. The I-V characteristics of two of such devices were measured, and the pixel resistance for a similar pixel size of 30 $\mu$m for both the devices and a similar thickness (~135 nm) was compared. The HeLi device shows an increase in the knee voltage of the I-V curves to ~1.2 V from ~0.7 V for the HoLi device, accompanied by an order of magnitude higher pixel resistance. Also, it was found that the TCR ranges between -1.6 to -5.3 %/K for the HoLi devices whereas for the HeLi device theTCR ranges between -2.4 to -7.5 %/K, for the studied temperature range of 270 to 340 K and the voltage bias of 0.1 to 1.0 V. Such high values of TCR exemplifies the importance and potential of HeLi QPBT structure devices which allows optimization of the figure-of-merits such as TCR for the development of high-quality devices with simple solution processing, and therefore at a reduced cost. Also, the noise performance of the devices was compared, by taking the FFT of the dark current scan at room temperature and in vacuum conditions. It was found that the current shot noise levels are $5.45 \times 10^{-12}$ and $8.68 \times 10^{-13}$A/$\sqrt{Hz}$ for HoLi and HeLi devices, respectively.

Third set of experiments

In this third set of experiments bolometers of two different geometries (device geometries) were developed, by integrating QDs-based PB thermistors (QPBT) with metal-insulator-metal-based plasmonic metamaterial absorbers (MIM-PMA).

The first device geometry is similar to the one of Fig. 9, and involves the use of an additional layer of large-sized QDs on top of the QPBT structure to function as the dielectric spacer for the MIM-PMA. A cross-sectional schematic of the device design is shown in Fig. 12 along with an SEM image of the device. The QPBT structure used in the device of Fig. 12 is identical to the DPB HeLi devices discussed further above, with small-sized QDs with an exciton peak around ~700 nm as the PB layer. Photolithography was used to pattern the substrates with the bottom electrode of Au (27 nm)/Ti (3 nm), and spin-coating was employed thereafter to develop the QPBT structure along with the alumina infilling method. The top electrode was prepared by photolithography and alumina etching method, followed by thermal deposition of Au (40 nm). Large-size QDs (~1900 nm) dots were then spin-coated to a thickness of ~80 nm, followed by e-beam lithography, metal evaporation, and lift-off to form the metamaterial pattern.

The devices were then loaded in a vacuum chamber to study their response under the illumination of IR light. For this purpose, a Quantum Cascade Laser (QCL) was utilized as the source of IR radiation in the range of 5.4- 12.8 $\mu$m. The laser beam from the QCL was made to bounce on a 90° off-axis parabolic Au mirror, which then reflects the laser beam to fall normally on the sample through a 3.1 mm thick Calcium Fluoride (CaF2) window. Two continuous variable temperature (CVT) probes in the vacuum chamber of the probe station allowed electrical connections to the device. The sample stage temperature was kept constant during the measurement with the help of LN$_2$ and temperature controllers. For the photocurrent measurements, the device was DC-biased using a low-noise current preamplifier, and the current output was fed to a lock-in amplifier. The reference frequency to the lock-in amplifier was provided from an optical chopper system.

To calculate the optical power falling on the device, the transmittance of the CaF$_2$ window as well as the laser beam power and spot size was measured. To calculate the laser beam power, a thermopile sensor was utilized in conjunction with a power meter. The sensor was placed at approximately the same distance as the sample from the Au mirror. The CaF$_2$ window shows a transmittance > ~93 % up to -7.3 $\mu$m wavelength and decays after that rapidly with ~50 % transmittance at 10 $\mu$m.

The devices were then subjected to optoelectronic measurement under IR illumination. A 1 mm thick borosilicate glass was used as the substrate due to very low thermal conductivity (~1.15 W/(m·K)), however, also absorbs the IR radiation strongly. To mitigate this effect, a reflecting 40 nm thick Au window was prepared around the plasmonic metamaterial absorber (PMA) to prevent radiation from reaching the substrate. The Au reflecting window allowed the detection of IR light directly by PMA, and a peak in the device current was observed which effectively matches the resonance peak of the PMA. The reflection window also affects the absorption of the PMA positively as it helps to confine the IR radiation more efficiently. The observation of a peak in the device exemplifies the suitable integration of the QDs-based QPBT and PMA structures, and the aptness of MIM-PMAs for the bolometer technology. The above-discussed fabrication steps and the process were followed for the development of QD bolometer devices reproducibly.

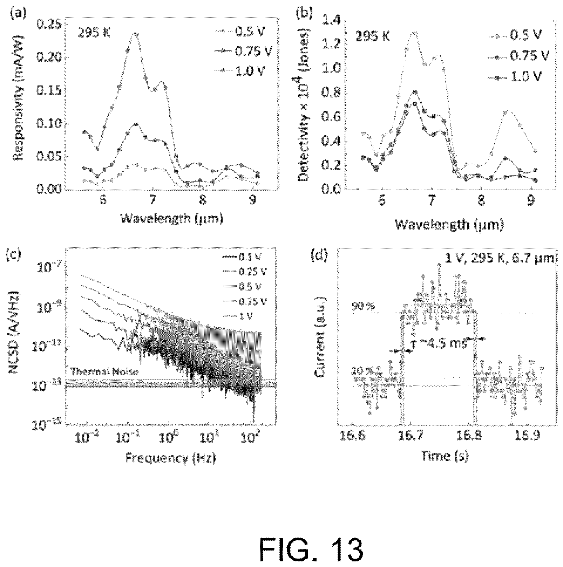

Fig. 13 shows the optoelectronic characterization data for one of the bolometer devices fabricated and characterized similarly. As shown in Fig. 13 (a), the device response shows a peak in the spectrum with the wavelength corresponding to the resonant wavelength of the PMA, as seen earlier. The responsivity spectrum was measured with a lock-in technique with a 4 Hz chopping frequency. As seen, the responsivity increases with the bias voltage. The maximum observed responsivity was around ~0.24 mA/W for a maximum of 1 V applied bias. Fig. 13 (b) shows the detectivity D* of the device as a function of the applied bias. The device's detectivity showed a reverse trend as compared to the responsivity and was found to be highest at 0.5 V and lowest at 1.0 V. The highest detectivity measured was ~$1.3 \times 10^4$ Jones under 0.5 V bias operation.

To calculate detectivity, the NSCD for the QPBT structure was evaluated using the FFT method as discussed further above and as shown in Fig. 13 (c) which also shows the thermal noise levels. The shot noise levels are ~$1.2 \times 10^{-13}$ for 0.1 V, -$2.15 \times 10^{-13}$ for 0.25 V, ~$4 \times 10^{-13}$ for 0.5 V, ~$6.25 \times 10^{-13}$ for 0.75 V, and ~$9.24 \times 10^{-13}$ A/√Hz for 1 V. In addition to this, the device's transient response was measured at an applied bias of 1 V with the help of a semiconductor analyzer. To do this, the sampling interval of the measurement was set to 2 ms (minimum possible), and the device current was measured in a constant voltage bias mode, as shown in Fig. 13 (d). To determine the rise and fall time of the device's response with 4 Hz optical chopping frequency, 10 to 90 % criteria were adopted. The time it takes for the device response to reach from 10 to 90 % of its steady-state value is termed the rise time, while the opposite is called the fall time. The device showed a seemingly faster response with this measurement as can be seen, with a similar rise and fall time of ~4.5 ms.

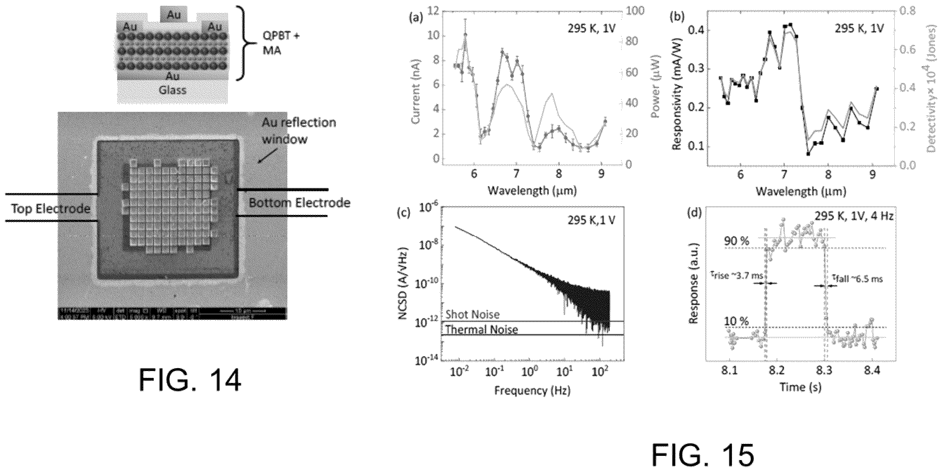

The second device geometry studied is similar to the one of Fig. 4, and involves the utilization of the QPBT structure as the dielectric spacer of the metamaterial absorber (MA). The utilization of the QPBT structure as the dielectric spacer of the MA allows for minimizing the number of layers in the device and therefore the thermal capacitance $C_{th}$ of the bolometer. The thermal capacitance is defined as the heat flow necessary to change the temperature of a medium by one unit. Moreover, as the MA is not in contact with the top metal electrode (i.e. the thermistors first electrode) directly, it is expected to allow for a reduction in the thermal loss due to heat conduction via electrodes. The device schematic and the SEM image of the studies device are shown in Fig. 14. In the device of Fig. 14 the square blocks of the metamaterial pattern, and the top electrode (first electrode) and bottom electrode (second electrode) were made of gold (Au). All the fabrication steps discussed until now have also been utilized in the development of this device. After fabricating the QPBT structure, which featured a rectangular frame-type top electrode on a borosilicate glass substrate, lithography was conducted to safeguard the contact pads. Subsequently, a 40 nm-thick layer of SiOz was deposited by the e-beam evaporation method onto the device. This layer served the dual purpose of separating the top Au window from the top electrodes and functioning as a dielectric layer within the MA structure. After the lift-off, the MA was patterned by e-beam lithography following the previously described procedure. Finally, a top Au window was patterned on the device to shadow the glass substrate and work as a collimator for the light falling on the device. The Au window has a thickness of 40 nm, which is greater than the skin depth of IR light and hence can be assumed to work as an efficient IR reflector. For the device shown, the MA has a size of 1.5 $\mu$m with a gap of 300 nm. The QPBT structure of the device of Fig. 14 was identical to the one used for the device with the aforementioned DPB HeLi configuration. Fig. 15 shows the optoelectronic characterization data of one of the primary devices performed under vacuum conditions. Fig. 15 (a) compares the thermal current as captured by the lock-in amplifier with a reference chopping frequency of 4 Hz. The thermal current follows closely the laser beam power apart from the resonant absorption region of the MA. An increase in the device current can be observed at the resonant peak of the MA, demonstrating the optimal functioning of the MA structure. The device's responsivity and detectivity reach a peak value of ~0.41 mA /W and ~$0.7 \times 10^4$ Jones, respectively at the illumination wavelength of -7.1 $\mu$m, as shown in Fig. 15 (b). The NCSD of the device is shown in Fig. 15 along with the shot noise and thermal noise levels for a bias voltage of 1V, evaluated by taking the FFT of the steady-state dark current of the device. The sampling interval and the ADC integration factor were kept to 2 ms and 1 respectively. The thermal noise floor and the shot noise floor were found to be $2.2 \times 10^{-13}$ and $1.2 \times 10^{-12}$ A/√Hz respectively, and the Hooge's parameter was evaluated to be around ~$1.2 \times 10^{-8}$ at 1 Hz. The device's transient response was further characterized by using the semiconductor analyzer with the minimum 2 ms sampling interval, which results in a time stamp of ~4 ms, as shown in Fig. 15(d). The rise time and fall time of the device were estimated using the 10 to 90 % criteria, which resulted in values of ~3.7 ms and ~6.5 ms respectively.

In this text, the term "comprises" and its derivations (such as "comprising", etc.) should not be understood in an excluding sense, that is, these terms should not be interpreted as excluding the possibility that what is described and defined may include further elements, steps, etc. In the context of the present disclosure, a deviation within reasonable limits from any exact value or values indicated in the present disclosure, should be accepted, because a skilled person in the art will understand that such a deviation from the values indicated is inevitable due to measurement inaccuracies, etc. Unless something else is explicitly stated, all ranges mentioned in this document include the end points of the respective range. Thus, for example, a range indicated using an expression such as "between X and Y" includes X and Y

The invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

Results incorporated in this specification have received funding from the European Research Council (ERC) under the European Union's Horizon 2020 research and innovation programme (grant agreement No 101002306).

References

[1]. G. L. Whitworth, M. Dalmases, N. Taghipour, and G. Konstantatos, "Solution-processed PbS quantum dot infrared laser with room-temperature tunable emission in the optical telecommunications window," Nat Photonics, vol. 15, no.

10, pp. 738-742, Oct. 2021, doi: 10.1038/s41566-021-00878-9.

[2] S. Christodoulou et al., "Single-Exciton Gain and Stimulated Emission Across the Infrared Telecom Band from Robust Heavily Doped PbS Colloidal Quantum Dots," Nano Lett, vol. 20, no. 8, pp. 5909-5915, Aug. 2020, doi: 10.1021/acs.nanolett.0c01859.

**Claims**

1. A thermistor comprising two electrodes (2, 3) and a layered structure (4) in contact with the two electrodes (2, 3), wherein the layered structure (4) comprises at least one first layer (4a) comprising first colloidal quantum dots, and at least one second layer (4b) comprising second colloidal quantum dots which differ from the first colloidal quantum dots.

2. A thermistor according to claim 1, wherein there is an electronic band offset between the first and second colloidal quantum dots.

3. A thermistor according to any of the preceding claims, wherein the first and second colloidal quantum dots are made of the same material.

4. A thermistor according to any of the preceding claims wherein the first colloidal quantum dots differ in size and/or bandgap than the second colloidal quantum dots.

5. A thermistor according to any of the preceding claims, wherein the at least one first layer (4a) comprises a first ligand material attached to the first colloidal quantum dots, and the at least one second layer (4b) comprises a second ligand material which is attached the second colloidal quantum dots and is different from the first ligand material.

6. A thermistor according to any of the preceding claims wherein the at least one first layer (4a) and the at least one second layer (4b) exhibit with respect to each other any of a different doping, a different Fermi level or a band offset.

7. A thermistor according to any of the preceding claims, the at least one first layer (4a) and the at least one second layer (4b) are arranged alternately in the layered structure (4) such that each of the at least one first layer (4a) contacts a corresponding one of the at least one second layer (4b), more preferably the at least the at least one first layer (4a) and the at least one second layer (4b) being configured to form at least one potential barrier structure

8. A thermistor according to any of the preceding claims, wherein the at least one first layer (4a) and/or the at least one second layer (4b) are a respective semiconductive colloidal quantum dot solid, preferably said respective semiconductive colloidal quantum dot solid having a majority carrier concentration of $10^{18}$ cm$^{-3}$ or more at a temperature of 300 K, more preferably the majority carrier concentration being $10^{19}$ cm$^{-3}$ or more at a temperature of 300 K.

9. A thermistor according to any of the preceding claims, wherein the layered structure (4) at a temperature of 300 K and under the application of a voltage of between 0.1 and 1V between the two electrodes (2, 3) is configured to have a negative temperature coefficient of resistance, TCR, the absolute value of which is equal to or more than 1 %/K, preferably equal to or more than 3 %/K, more preferably equal to or more than 5 %/K.

10. A bolometer comprising a thermistor according to any of the previous claims.

11. A bolometer according to claim 10, wherein the first and/or the second colloidal quantum dots are configured to absorb infrared radiation, preferably via intra-band excitation of charge carriers in the colloidal quantum dots.

12. A bolometer according to any of claims 10-11, comprising an absorber which is configured to absorb infrared radiation and convert at least part of the absorbed radiation into heat, wherein the absorber is integrated or is in thermal contact with the layered structure (4) of the thermistor.

13. A bolometer according to claim 12, wherein the absorber is a layered plasmonic metamaterial absorber which is configured to resonantly absorb the mid- and/or long-wavelength infrared radiation and comprises a metallic base layer (10), a metamaterial pattern (8) and an optical spacer (9) which is arranged between the metallic base layer (10) and the metamaterial pattern (8), preferably the optical spacer (9) comprising colloidal quantum dots, more preferably the layered structure (4) of the thermistor forming the optical spacer (9).

14. A bolometer according to any of claim 10-14, further comprising a substrate (7) which comprises an air bridge (12) which supports the thermistor which is at the air bridge (12).

15. An image sensor comprising a plurality of pixels, wherein each pixel comprises a respective bolometer which is according any of claims 10-14.

FIG. 1A

FIG. 1B

FIG. 2A

FIG. 2B

FIG. 3

FIG. 4

FIG. 5

FIG. 6

FIG. 7

FIG. 8

FIG. 9

FIG. 10A

FIG. 10B

FIG. 11

FIG. 12

FIG. 13

FIG. 14

FIG. 15

EP 4 726 341 A1

Europäisches
Patentamt
European
Patent Office
Office européen
des brevets

# EUROPEAN SEARCH REPORT

**Application Number**

EP 24 38 3106

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Kumar Gaurav: "Colloidal quantum dots based bolometers", Universitat Politecnica de Catalunya, PhD Thesis, 11 March 2024 (2024-03-11), XP093262330, Retrieved from the Internet: URL:https://tesisenred.net/handle/10803/690664 [retrieved on 2025-03-21] | 1-4,6-15 | INV. G01J5/02 B82Y20/00 B82Y30/00 G01J5/04 G01J5/08 G01J5/20 |
| A | * the whole document * | 5 | |
| A | EP 1 912 259 A1 (ACREO AB [SE]) 16 April 2008 (2008-04-16) * paragraph [0029] - paragraph [0068] * * figures 1-6 * | 2,6,8, 11,14 | |
| A | HAFIZ SHIHAB BIN ET AL: "Colloidal quantum dots for thermal infrared sensing and imaging", NANO CONVERGENCE, [Online] vol. 6, no. 1, 5 March 2019 (2019-03-05), XP093252252, ISSN: 2196-5404, DOI: 10.1186/s40580-019-0178-1 Retrieved from the Internet: URL:http://link.springer.com/article/10.1186/s40580-019-0178-1/fulltext.html> [retrieved on 2025-03-20] * the whole document * | 1-15 | |

**TECHNICAL FIELDS SEARCHED (IPC)**

G01J
B82Y

The present search report has been drawn up for all claims

| Place of search | Date of completion of the search | Examiner |
|---|---|---|
| Munich | 28 March 2025 | Haller, Mirjam |

EPO FORM 1503 03.82 (P4C01)

## ANNEX TO THE EUROPEAN SEARCH REPORT
## ON EUROPEAN PATENT APPLICATION NO.

EP 24 38 3106

This annex lists the patent family members relating to the patent documents cited in the above-mentioned European search report.
The members are as contained in the European Patent Office EDP file on
The European Patent Office is in no way liable for these particulars which are merely given for the purpose of information.

28-03-2025

| Patent document cited in search report | Publication date | Patent family member(s) | Publication date |
|---|---|---|---|
| EP 1912259 A1 | 16-04-2008 | NONE | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G. L. WHITWORTH** ; **M. DALMASES** ; **N. TAGHI-POUR** ; **G. KONSTANTATOS**. Solution-processed PbS quantum dot infrared laser with room-temperature tunable emission in the optical telecommunications window. *Nat Photonics*, October 2021, vol. 15 (10), 738-742

- **S. CHRISTODOULOU et al.** Single-Exciton Gain and Stimulated Emission Across the Infrared Telecom Band from Robust Heavily Doped PbS Colloidal Quantum Dots. *Nano Lett*, August 2020, vol. 20 (8), 5909-5915